# EUROPEAN PATENT APPLICATION

(11) **EP 4 083 276 A1**
(43) Date of publication of application: **02.11.2022**
(21) Application number: 22168735.3
(22) Date of filing: 19.04.2022
(51) Int. Cl.: C30B 15/00, C01F 17/34, C30B 15/08, C30B 29/28, H01S 3/00, H01S 3/06, H01S 3/16

(54) **ABSORBING MATERIAL BASED ON SAMARIUM-DOPED GARNET FOR SUPPRESSION OF AMPLIFIED SPONTANEOUS EMISSION OF THE ACTIVE MEDIUM OF SOLID-STATE LASER, USE OF THIS MATERIAL, METHOD OF ITS PRODUCTION AND MONOLITHIC ELEMENT CONTAINING THIS ABSORBING MATERIAL**

(30) Priority: 27.04.2021 CZ 20210213
(71) Applicant: Crytur, Spol.S R.O., 51101 Turnov (CZ); Fyzikální ústav AV CR, v.v.i., 18221 Praha 8 (CZ)
(72) Inventor: Nejezchleb, Karel, 51101 Mírová pod Kozákovem (CZ); Nikl, Martin, 18200 Praha 8 (CZ); Pejchal, Jan, 67571 Nám nad Oslavou (CZ)
(74) Representative: Sedlák, Jirí

(57) **Abstract**

The present invention relates to an absorbing material based on samarium-doped garnet with the general chemical formula (ReₐSm_{d}Scₑ)₃(ALₓSC_{y}Ga_{z})₅O₁₂ for suppression of the amplified spontaneous emission of the active medium of solid-state laser, its use to form a monolithic element and method of production. The invention further relates to a monolithic element comprising layers of the absorbing material configured on opposite walls of the active medium Nd:YAG, which is formed in the shape of block, for suppression of amplified spontaneous emission of the active medium of a solid-state laser.

## Description

### Field of the Invention

The invention relates to the field of solid-state lasers, in particular an absorbing material based on samarium-doped garnet for suppression of amplified spontaneous emission of the active medium of a solid-state laser, its use and method of production, and a monolithic element containing this material.

### Background of the Invention

Solid-state lasers are a group of lasers that use a crystal to adjust wavelength. The most widely used and currently the best technically mastered solid-state laser is the "Nd:YAG", i.e. neodymium-doped yttrium aluminium garnet. The material of the active medium of such a solid-state laser is an isotropic crystal of yttrium aluminium garnet Y₃Al₅O₁₂ doped with neodymium ions (Nd³⁺). The typical emission wavelength from an Nd:YAG laser is 1064 nm. It is most often pumped by a xenon lamp or a laser diode.

Amplified spontaneous emission (ASE) is a phenomenon in which a spontaneously emitted photon causes the emission of more photons that propagate through the active medium. Spontaneously emitted radiation, which propagates in the active medium in in the direction of the resonator axis, is amplified in the active medium. Amplified spontaneous emission is generated in the intensively pumped active medium of solid-state laser, in particular when it is a high-gain active medium, such as neodymium-doped yttrium aluminium garnet (Nd:YAG).

Amplified spontaneous emission is not coherent and limits the achievable laser power; in addition, it may be accompanied by the formation of parasitic oscillations for some amplification trajectories. Parasitic oscillations are particularly problematic with high performance amplifiers that have large transverse dimensions compared to thickness. Parasitic oscillations can be prevented by depositing an absorbing layer or layers of absorbing material on the periphery of the material of the active medium. The required layer thickness of the absorbing material is inversely proportional to the magnitude of the absorption coefficient at the wavelength of amplified spontaneous emission. This implies the requirement for high absorption coefficient of the absorbing material at the wavelength of the amplified spontaneous emission. From the point of view of the geometry of the active medium of solid-state laser, it is preferred if the layer of the absorbing material absorbs the amplified spontaneous emissions at its wavelength and at the same time is transparent for the wavelength at which the active medium is pumped by semiconductor diodes.

For the specific case of active medium of the neodymium-doped yttrium aluminium garnet (Nd:YAG), the wavelength of amplified spontaneous emission is 1064 nm and the pump wavelength is 808 nm. Samarium-doped yttrium aluminium garnet (Sm:YAG) is generally selected as the absorbing material, which is diffusely bonded with the material of the active medium, i.e. neodymium-doped yttrium aluminium garnet (Nd:YAG). In the production of this concept, Sm:YAG is produced by growing a single crystal from a melt with samarium doping or is prepared from powdered raw materials by sintering. However, due to the structure of YAG, these solutions provide a material with a relatively low concentration of samarium. A further disadvantage of this configuration is the absorption spectrum of the Sm:YAG absorbing material, where the position of the absorption peak is outside the wavelength of the amplified spontaneous emission at 1064 nm in the Nd:YAG active medium.

Therefore, the task of the invention is to provide such an absorbing material based on samarium-doped garnet for suppression of amplified spontaneous emission of the active medium of a solid-state laser, which, without limiting laser power, would absorb amplified spontaneous emissions of the material of the active medium Nd:YAG by its absorption peak around 1064 nm and at the same time was transparent at the wavelength at which the active medium is pumped by active diodes.

### Summary of the Invention

The task is solved by an absorbing material based on samarium-doped garnet for suppression of amplified spontaneous emission of the active medium of a solid-state laser. The core of the present invention is that the absorbing material corresponds to the general chemical formula (ReₐSm_{d}Scₑ)₃(AlₓSc_{y}Ga_{z})₅O₁₂, where
the substituent Re represents at least one cation selected from the group: Y³⁺ or a cation from
the group of lanthanides or a combination thereof,
the stoichiometric coefficient "a" lies in the interval 0.01 < a < 0.95,
the stoichiometric coefficient "d" lies in the interval 0.05 < d < 1,
the stoichiometric coefficient "e" in the dodecahedral position of the crystal lattice lies in the interval 0.01 < e < 0.3,
where the following relationship applies to the sum of the coefficients a, d, e: a + d + e = 1;
the stoichiometric coefficient "y" in the octahedral position of the crystal lattice lies in the interval 0.1 < y < 0.5,
the stoichiometric coefficient "x" lies in the interval 0.01 < x < 0.9,
and the stoichiometric coefficient "z" lies in the interval 0 < z < 0.9,
where the following relationship applies to the sum of the coefficients y, x, z: y + x + z = 1.

The content of samarium ions in the absorbing material is greater than 15 mol%. Due to the structure and chemical composition of the absorbing material, high concentrations of samarium can be achieved which results in high absorption coefficient of the absorbing material in the wavelength range around 1064 nm. Thus, the absorbing material contains an absorption band in the absorption spectrum with a maximum at the wavelength of 1064 (+/- 2) nm. At the same time, the absorbing material has minimal absorption at the wavelength of 808 nm, which allows the active medium Nd:YAG to be pumped through the absorbing material providing an advantage for the design of a solid-state laser.

In the preferred design, the cation is selected from the group of lanthanides: La, Ce, Pr, Sm, Eu, Gd, Tb, Dy, Ho, Er, Tm, Yb, Lu. Preferably, the cation from the group of lanthanides is Gd.

The present invention also relates to the use of the absorbing material described above to form a monolithic element, where the absorbing material is assembled on at least two sides of the active medium of the solid-state laser.

The present invention further provides a method of producing the absorbing material described above. The core of the present invention is that the absorbing material is prepared by growing a single crystal from a melt consisting of the mixture of rare earth oxides such as Y₂O₃, Sm₂O₃ or Gd₂O₃ and aluminium oxide Al₂O₃ or scandium oxide Sc₂O₃ or gallium oxide Ga₂O₃ When growing a single crystal, the respective mixture of oxides is mixed at a given ratio, then itis heated to a temperature of about 1900°C, and then the single crystal of the absorbing material gradually grows from the melt.

The present invention further provides a method of producition of the absorbing material described above. The core of the present invention is that the absorbing material is prepared by solid-state sintering from powder raw materials of a mixture of rare earth oxides, such as Y₂O₃, Sm₂O₃ or Gd₂O₃ and aluminium oxide Al₂O₃ or scandium oxide Sc₂O₃ or gallium oxide Ga₂O₃ This is basically the same chemical composition of raw materials as in the case of the of the single crystal growth, but they differ in grain size of the powdered raw materials, which are more reactive, so the so-called nano-powders are used, i.e. powder raw materials with grain size in nm range. The sintering process takes place in the solid phase at the temperature lower than the melting point, i.e. at lower temperatures compared to the single crystal growth. The final product is a transparent ceramics of the absorbing material.

Since the absorbing material described above has a garnet structure, it can be diffusely assembled with the Nd:YAG active medium to form monolithic structures consisting of the segments of Nd:YAG and the absorbing material with a higher content of samarium (Sm). The present invention therefore further relates to a monolithic element comprising at least one segment formed by the active medium of a solid-state laser based on a neodymium-doped yttrium aluminium garnet (Nd:YAG), which is in the shape of block and is assembled with a layer of absorbing material based on samarium-doped garnet on at least two sides for suppression of the amplified spontaneous emission of the active medium of the solid-state laser.

The core of the present invention is that the absorbing material in the monolithic element corresponds to the general chemical formula (ReₐSm_{d}Scₑ)₃(AlₓSc_{y}Ga_{z})₅O₁₂, where the substituent Re represents at least one cation selected from the group: Y³⁺ or a cation from the group of lanthanides or a combination thereof,
the stoichiometric coefficient "a" lies in the interval 0.01 < a < 0.95,
the stoichiometric coefficient "d" lies in the interval 0.05 < d < 1,
the stoichiometric coefficient "e" in the dodecahedral position of the crystal lattice lies in the interval 0.01 < e < 0.3,
where the following relationship applies to the sum of the coefficients a, d, e: a + d + e = 1; the stoichiometric coefficient "y" in the octahedral position of the crystal lattice lies in the interval 0.1 < y < 0.5,
the stoichiometric coefficient "x" lies in the interval 0.01 < x < 0.9,
and the stoichiometric coefficient "z" lies in the interval 0 < z < 0.9,
where the following relationship applies to the sum of the coefficients y, x, z: y + x + z = 1. The content of the samarium ions in the absorbing material is greater than 15 mol%.

In a preferred composition, the cation from the group of lanthanides is selected from the group: La, Ce, Pr, Sm, Eu, Gd, Tb, Dy, Ho, Er, Tm, Yb, Lu. Preferably, the cation from the group of lanthanides is Gd.

The block-shaped monolithic element, whose active medium Nd:YAG is surrounded on two sides by layers of the absorbing material, has the outer side walls of the segment of the active medium in a preferred configuration ground or polished to allow good thermal contact with the cooling medium to remove heat from the active medium. The outer surfaces of the layer of the absorbing material are finished in a way that pumping radiation from semiconductor diodes in the wavelength range from 780 to 825 nm can pass into the active medium through the absorbing material, so they are polished and assembled with dielectric layers for the passage of radiation.

The following relationship applies to the thickness of the layer of absorbing material in the monolithic segment: t > gL/α, where
- t -: is the thickness of the layer of absorbing material
- g -: is the gain in the active medium per unit thickness of the segment of the active medium
- L -: is the thickness of the segment of the active medium
- α - i: s the absorption coefficient at the wavelength of amplified spontaneous emission (ASE).

The advantages of the the absorbing material based on the samarium-doped garnet for suppression of the amplified spontaneous emission of the active medium of a solid-state laser according to the present invention are in particular that it does not limit the laser power, absorbs amplified spontaneous emission of the material of the active medium Nd:YAG at the wavelength, i.e. its absorption peak is around 1064 nm and at the same time it is transparent at the wavelength at which the active medium is pumped by active diodes.

### Explanation of drawings

The present invention will be explained in detail using the following figures where:
- Fig. 1: shows a graph comparing the emission spectrum of Nd:YAG and the absorption spectrum of Sm:YAG from the prior art,
- Fig. 2: shows a view of a monolithic element according to the invention,
- Fig. 3: shows the absorption spectrum of the absorbing material around 1064 nm,
- Fig. 4: shows the absorption spectrum of the absorbing material around 808 nm,
- Fig. 5: shows a photograph of a single crystal of the absorbing material Gd_{2.6}Sm_{0.3}SC_{0.6}Al_{4.5}O₁₂ grown by micro-pulling-down (mPD) technique,
- Fig. 6: shows a photograph of a single crystal of the absorbing material Gd_{2.6}Sm_{0.3}Sc_{0.6}Al_{4.5}O₁₂ grown by Czochralski technique,
- Fig. 7: shows the absorption spectrum of a single crystal of the absorbing material Gd_{2.6}Sm_{0.3}Sc_{0.6}Al_{4.5}O₁₂,
- Fig. 8: shows the absorption spectrum of a single crystal of the absorbing material Gd_{2.6}Sm_{0.3}Sc_{0.6}Al_{4.5}O₁₂ with the subtracted reflection losses,
- Fig. 9: shows a photograph of a single crystal of the absorbing material Gd_{1.0}Y_{1.3}Sm_{0.6}Sc_{0.6}Al_{4.5}O₁₂ grown by mPD technique,
- Fig. 10: shows the absorption spectrum of a single crystal of the absorbing material Gd_{1.0}Y_{1.3}Sm_{0.6}Sc_{0.6}Al_{4.5}O₁₂,
- Fig. 11: shows a photograph of a single crystal of the absorbing material Gd_{1.0}Lu_{1.0}Sm_{0.9}Sc_{0.6}Al_{4.5}O₁₂ grown by mPD technique,
- Fig. 12: shows the absorption spectrum of a single crystal of the absorbing material Gd_{1.0}Lu_{1.0}Sm_{0.9}Sc_{0,6}Al_{4.5}O₁₂,
- Fig. 13: shows a photograph of a single crystal of the absorbing material Gd_{2.67}Sm_{0.3}Sm_{0.53}Ga_{3.4}Al_{0.1}O₁₂ grown by mPD technique,
- Fig. 14: shows the absorption spectrum of a single crystal of the absorbing material Gd_{2.67}Sm_{0.3}Sc_{1.53}Ga_{3.4}Al_{0.1}O₁₂.
- Fig. 15: shows a photograph of a single crystal of the absorbing material Gd_{1.0}Y_{1.37}Sm_{0.6}Sc_{1.53}Ga_{3.4}Al_{0.1}O₁₂ grown by mPD technique,
- Fig. 16: shows the absorption spectrum of a single crystal of the absorbing material Gd_{1.0}Y_{1.37}Sm_{0.6}Sc_{1.53}Ga_{3.4}Al_{0.1}O₁₂,
- Fig. 17: shows a photograph of a single crystal of the absorbing material Gd_{0.5}Lu_{0.5}Y_{0.77}Sm_{1.2}Sc_{1.53}Ga_{3.4}Al_{0.1}O₁₂ grown by mPD technique,
- Fig. 18: shows the absorption spectrum of a single crystal of the absorbing material Gd_{0.5}Lu_{0.5}Y_{0.77}Sm_{1.2}Sc_{1.53}Ga_{3.4}Al_{0.1}O₁₂,
- Fig. 19: shows a photograph of a single crystal of the absorbing material Gd_{0.67}La_{0.2}Sm_{2.1}Sc_{1.53}Ga_{3.4}Al_{0.1}O₁₂ grown by mPD technique,
- Fig. 20: shows the absorption spectrum of a single crystal of the absorbing material Gd_{0.67}La_{0.2}Sm_{2.1}Sc_{1.53}Ga_{3.4}Al_{0.1}O₁₂,
- Fig. 21: shows a photograph of a single crystal of the absorbing material Gd_{0.03}Sm_{2.94}Sc_{1.53}Ga_{3.4}Al_{0.1}O₁₂ grown by mPD technique,
- Fig. 22: shows the absorption spectrum of a single crystal of the absorbing material Gd_{0.03}Sm_{2.94}Sc_{1.53}Ga_{3.4}Al_{0.1}O₁₂.

### Example of the invention embodiments

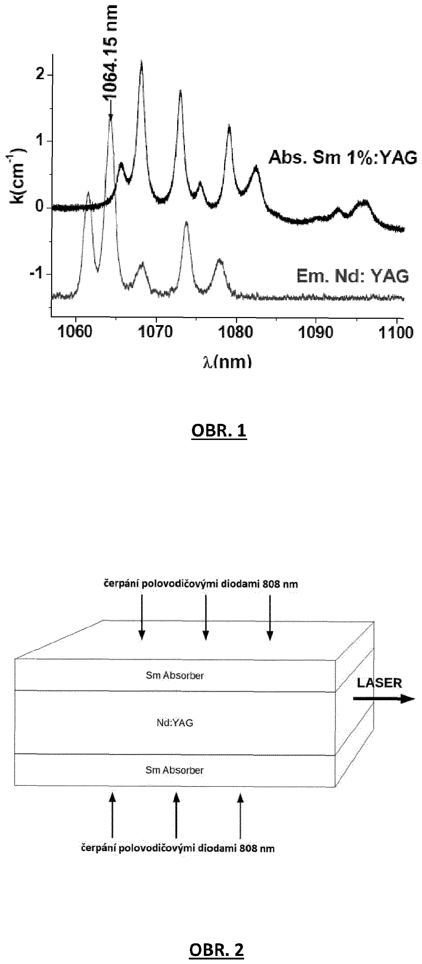

Fig. 1 shows a graph comparing the emission spectrum of Nd:YAG and the absorption spectrum of Sm:YAG from the prior art, showing that in the case of active medium of neodymium-doped yttrium aluminium garnet (Nd:YAG), the wavelength of the amplified spontaneous emission is 1064 nm and the absorbing material, samarium-doped yttrium aluminium garnet (Sm:YAG), has the absorption spectrum or the absorption peak outside the wavelength of amplified spontaneous emission in the material of the active medium Nd:YAG.

Fig. 2 shows a monolithic element according to the invention, the segment of which is formed by the active medium of the solid-state laser based on neodymium-doped yttrium aluminium garnet (Nd:YAG), which is in the shape of block and is provided with a layer of absorbing material based on samarium-doped garnet on two walls for suppression of the amplified spontaneous emission of the active medium of the solid-state laser pumped at the wavelength of 808 nm.

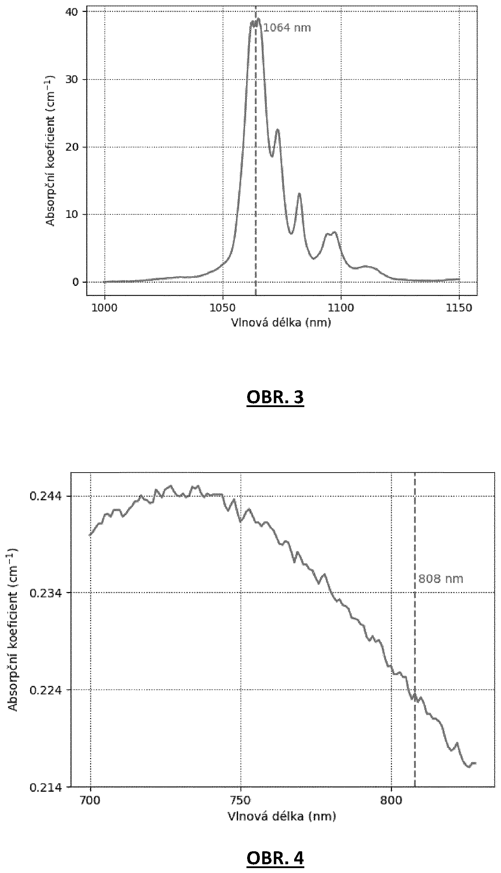

Fig. 3 shows a general graph of the absorption spectrum of the absorbing material of the present invention around 1064 nm. Fig. 4 shows a general graph of the absorption spectrum of the absorbing material of the present invention around 808 nm.

### Example 1

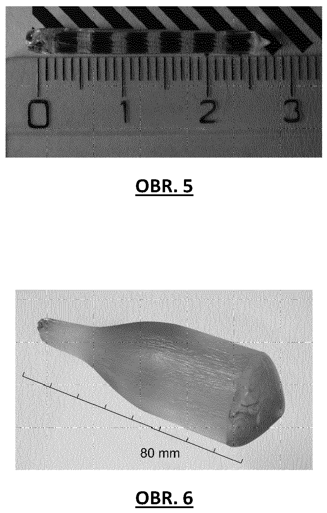

A sample of the single crystal of the absorbing material Gd_{2.6}Sm_{0.3}SC_{0.6}Al_{4.5}O₁₂ was prepared as follows:
In a total amount of 1 g, the binary oxides Gd₂O₃, Sc₂O₃ Al₂O₃, and Sm₂O₃ with a purity of 5N were mixed at the ratio of the chemical formula Gd_{2.6}Sm_{0.3}Sc_{0.6}Al_{4.5}O₁₂ as follows: Gd₂O₃ 0.59 g, Sc₂O₃ 0.0518 g, Al₂O₃ 0.2872 g, Sm₂O₃0.0709 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique: The starting material was placed in an iridium crucible with a circular die with a diameter of 3 mm and a capillary with a diameter of 0.5 mm at the bottom. The height of the after-heater was 20 mm. Both the crucible and the after-heater were inductively heated until the melting point of the starting material was reached. After contact of the seed non-doped single crystal Y₃Al₅O₁₂ in orientation <111> with the melt in the capillary, the crystal was pulled down at a rate of 0.03 mm/min until the melt in the crucible was depleted. Then, the induction heating power was gradually reduced until the room temperature, and the crystal was removed. The process took place under a protective atmosphere of N₂ with a purity of 99.99%, whose flow through the hot zone of the apparatus was 0.5 dm³/min. An example of a grown rod is shown in Fig. 5.

Crystals Gd_{2.3}Sm_{0.6}Sc_{0.6}Al_{4.5}O₁₂ (charges of Gd₂O₃ 0.52 g, Sc₂O₃ 0.0517 g, Al₂O₃ 0.2864 g, Sm₂O₃ 0.1415 g) and Gd_{2.0}Sm_{0.9}Sc_{0.6}Al_{4.5}O₁₂ (charges of Gd₂O₃ 0.4513 g, Sc₂O₃ 0.0515 g, Al₂O₃ 0.2855 g, Sm₂O₃ 0.2117 g) were prepared in the same manner by mPD technique to compare the characteristics. Since the total mass was again 1 g, the individual charges also correspond to the mass fractions.

Discs with a thickness of 1 mm were cut out of the finished single-crystal rods with a diameter of 3 mm and optically polished for the following measurement of absorption spectra.

An analogous single crystal with a composition of Gd_{2.6}Sm_{0.3}Sc_{0.6}Al_{4.5}O₁₂ was grown by Czochralski technique and is shown in Fig. 6. The growth was performed in a 1 I molybdenum crucible in the protective atmosphere composed of 30% hydrogen and 70% argon. Gadolinium aluminate GdAlO₃ and annealed oxides Sm₂O₃, SC₂O₃, Al₂O₃ were used as the starting charge in the crucible. The raw material was remelted before use for 24 hours. The YAG-oriented crystal (100) was used as the seed. The pulling rate was 0.8 mm/h, the rotation rate was 4 rpm. A disk with a diameter of 30 mm and a thickness of 1 mm was cut out of the crystal and optically polished for subsequent measurements of absorption spectra.

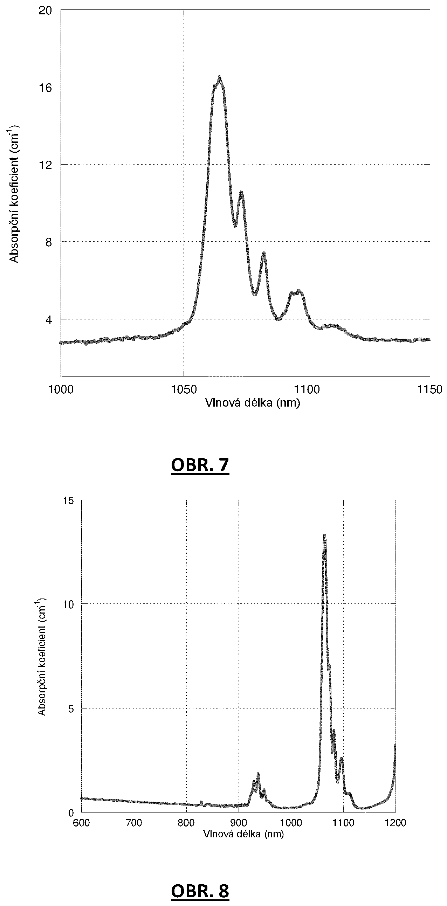

Fig. 7 shows the absorption spectrum of a Gd_{2.6}Sm_{0.3}Sc_{0.6}Al_{4.5}O₁₂ g single crystal grown by mPD technique with a thickness of 1 mm, where the absorption coefficient at 1064 nm reaches the value of 16.1 cm⁻¹. In the Gd_{2.3}Sm_{0.6}Sc_{0.6}Al_{4.5}O₁₂ and Gd_{2.0}Sm_{0.9}Sc_{0.6}Al_{4.5}O₁₂ crystals grown by mPD technique, the absorption coefficient at 1064 nm reaches the values of 28.5 cm⁻¹ and 40.6 cm⁻¹. In the Gd_{2.6}SM_{0.3}SC_{0.6}Al_{4.5}O₁₂ crystal grown by Czochralski technique, the absorption coefficient at 1064 nm reaches the value of 15.8 cm⁻¹. Fig. 8 shows a detail of the absorption spectrum of the Gd_{2.6}Sm_{0.3}Sc_{0.6}Al_{4.5}O₁₂ single crystal with a thickness of 1 mm, measured in a wider range of 600 to 1200 nm, where the reflection losses are subtracted.

### Example 2

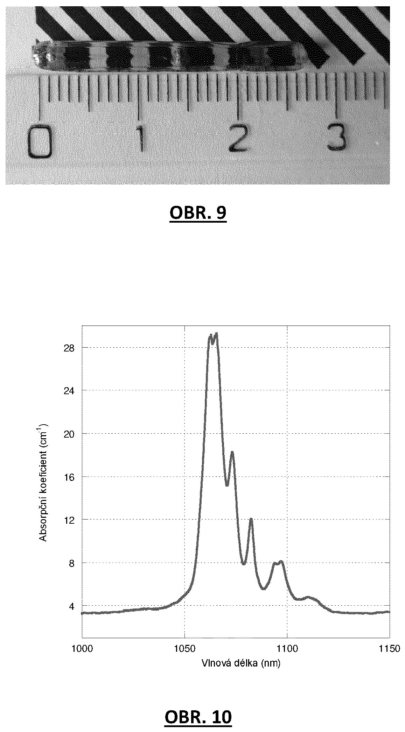

A sample of the single crystal of the Gd_{1.0}Y_{1.3}Sm_{0.6}Sc_{0.6}Al_{4.5}O₁₂ absorbing material was prepared as follows:
In a total amount of 1 g, the binary oxides Gd₂O₃, Y₂O₃ Sc₂O₃ Al₂O₃, and Sm₂O₃ with a purity of 5N were mixed at the ratio of the chemical formula Gd_{1.0}Y_{1.3}Sm_{0.6}Sc_{0.6}Al_{4.5}O₁₂ as follows: Gd₂O₃ 0.2221 g, Y₂O₃ 0.3073 g, Sc₂O₃ 0.0507 g, Al₂O₃ 0.2811 g, Sm₂O₃ 0.1389 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from a molybdenum crucible, see example of the grown rod in Fig. 9.

The starting powder was placed in a molybdenum crucible with a circular die with a diameter of 3 mm and a capillary with a diameter of 0.5 mm at the bottom. The height of the after-heater was 20 mm. Both the crucible and the after-heater were inductively heated until the melting point of the starting material was reached. After contact of the undoped Y₃Al₅O₁₂ single crystal seed(<111> orientation) with the melt in the capillary, the crystal was pulled down at a rate of 0.03 mm/min until the melt in the crucible was depleted. Then, the induction heating power was gradually reduced until cooling to room temperature, and the crystal was removed. The process took place under a protective atmosphere of Ar+5%H₂ with a purity of 99.99%, whose flow through the hot zone of the apparatus was 0.5 dm³/min.

Crystals Gd_{1.0}Y_{1.6}Sm_{0.3}Sc_{0.6}Al_{4.5}O₁₂ (charges of Gd₂O₃ 0.2217 g, Y₂O₃ 0.3776 g, Sc₂O₃ 0.0506 g, Al₂O₃ 0.2807 g, Sm₂O₃ 0.0693 g) and Gd_{1.0}Y_{1.0}Sm_{0.9}Sc_{0.6}Al_{4.5}O₁₂ (charges of Gd₂O₃ 0.2224 g, Y₂O₃ 0.2367 g, Sc₂O₃ 0.0508 g, Al₂O₃ 0.2815 g, Sm₂O₃ 0.2086g) were prepared in the same manner to compare their characteristics. Since the total mass was again 1 g, the individual charges also correspond to the mass fractions.

Discs with a thickness of 1 mm were cut out of the single-crystal rods with a diameter of 3 mm and optically polished for the following measurement of absorption spectra.

Fig. 10 shows the absorption spectrum of a Gd_{1.0}Y_{1.3}Sm_{0.6}Sc_{0.6}Al_{4.5}O₁₂ single crystal, where the absorption coefficient at 1064 nm reaches the value of 28.7 cm⁻¹. In the Gd_{1.0}Y_{1.6}Sm_{0.3}Sc_{0.6}Al_{4.5}O₁₂ and Gd_{1.0}Y_{1.0}Sm_{0.9}Sc_{0.6}Al_{4.5}O₁₂ crystals, the absorption coefficient at 1064 nm reaches the values of 15.9 cm⁻¹ and 40.3 cm⁻¹, respectively.

### Example 3

A sample of a single crystal of the absorbing material Gd_{1.0}Lu_{1.0}Sm_{0.9}Sc_{0.6}Al_{4.5}O₁₂ was prepared as follows:
In a total amount of 1 g, the binary oxides Gd₂O₃, Lu₂O₃ Sc₂O₃ Al₂O₃, and Sm₂O₃ with a purity of 5N were mixed at the ratio of the chemical formula Gd_{1.0}Lu_{1.0}Sm_{0.9}Sc_{0.6}Al_{4.5}O₁₂ as follows: Gd₂O₃ 0.2208 g, Lu₂O₃ 0.2423 g, Sc₂O₃ 0.0504 g, Al₂O₃ 0.2794 g, Sm₂O₃ 0.2071 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from a molybdenum crucible, see example of the grown rod in Fig. 5.

Crystals Gd_{1.0}Lu_{1.6}Sm_{0.3}Sc_{0.6}Al_{4.5}O₁₂ (charges of Gd₂O₃ 0.2191 g, Lu₂O₃ 0.3849 g, Sc₂O₃ 0.05 g, Al₂O₃ 0.2774 g, Sm₂O₃0.0685 g) and Gd_{1.0}Lu_{1.3}Sm_{0.6}Sc_{0.6}Al_{4.5}O₁₂ (charges of Gd₂O₃0.22 g, Lu₂O₃ 0.3139 g, Sc₂O₃ 0.0502 g, Al₂O₃ 0.2784 g, Sm₂O₃0.1376 g) were prepared in the same manner to compare their characteristics.

The starting material was placed in a molybdenum crucible with a circular die with a diameter of 3 mm and a capillary with a diameter of 0.5 mm at the bottom. The height of the after-heater was 20 mm. Both the crucible and the after-heater were inductively heated until the melting point of the starting material was reached. After the contact of the non-doped single crystal Y₃Al₅O₁₂ seed (orientation <111>) with the melt in the capillary, the crystal was pulled down at a rate of 0.03 mm/min until the melt in the crucible was depleted. Then, the induction heating power was gradually reduced until room temperature, and the crystal was removed. The process took place under a protective atmosphere of Ar+5%H₂ with a purity of 99.99%, whose flow through the hot zone of the apparatus was 0.5 dm³/min.

Disks with a thickness of 1 mm were cut out of the finished single-crystal rods with a diameter of 3 mm and optically polished for the following measurement of the absorption spectra.

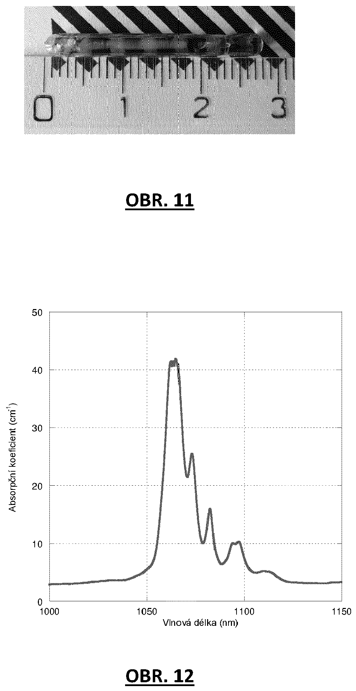

Fig. 12 shows the absorption spectrum of the Gd_{1.0}Lu_{1.0}Sm_{0.9}Sc_{0.6}Al_{4.5}O₁₂ single crystal, where the absorption coefficient at 1064 nm reaches the value of 40.8 cm⁻¹. In the Gd_{1.0}Lu_{1.6}Sm_{0.3}Sc_{0.6}Al_{4.5}O₁₂ and Gd_{1.0}Lu_{1.3}Sm_{0.6}Sc_{0.6}Al_{4.5}O₁₂ crystals, the absorption coefficient at 1064 nm reaches the values of 16.3 cm⁻¹ and 28.4 cm⁻¹, respectively.

### Example 4

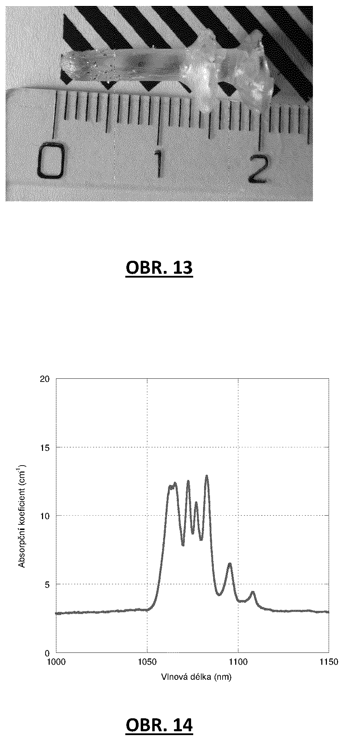

A sample of single crystal of the absorbing material Gd_{2.67}SM_{0.3}Sc_{1.53}Ga_{3.4}Al_{0.1}O₁₂, was prepared as follows:
In a total amount of 1 g, the binary oxides Gd₂O₃, Sc₂O₃ Al₂O₃, Ga₂O₃ and Sm₂O₃ with a purity of 5N were mixed at the ratio of the chemical formula Gd_{2.67}SM_{0.3}SC_{1.53}Ga_{3.4}Al_{0.1}O₁₂ as follows: Gd₂O₃ 0.4990 g, Sc₂O₃ 0.1088 g, Al₂O₃ 0.0053 g, Ga₂O₃ 0.3286 g, Sm₂O₃ 0.0584 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from an iridium crucible, see example of grown rod in Fig. 13.

The starting material was placed in an iridium crucible with a circular die with a diameter of 3 mm and a capillary with a diameter of 0.5 mm at the bottom. The height of the after-heater was 20 mm. Both the crucible and the after-heater were inductively heated until the melting point of the starting material was reached. After contact of the undoped Y₃Al₅O₁₂ seed crystal ( orientation <111>) with the melt in the capillary, the crystal was pulled down at a rate of 0.03 mm/min until the melt in the crucible was depleted. Then, the induction heating power was gradually reduced down to room temperature, and the crystal was removed. For the Ga-containing crystals, the whole process took place only in an Ir crucible under the atmosphere of gaseous mixture of 1% oxygen with a purity of 99.998% in argon with a purity of 99.998% (Ar: 1% O₂). The flow rate of Ar: Ar + 1% O₂ was 0.5 dm³/min. Oxygen was introduced to suppress Ga evaporation associated with decomposition of Ga₂O₃ The molybdenum crucible could not be used due to the reaction of Mo with Ga₂O₃ and with O₂.

The Gd_{2.37}Sm_{0.6}Sc_{1.53}Ga_{3.4}Al_{0.1}O₁₂ (charges of Gd₂O₃ 0.4419 g, Sc₂O₃ 0.1085 g, Al₂O₃ 0.0052 g, Ga₂O₃ 0.3278 g, Sm₂O₃0.1166 g) and Gd_{2.07}Sm_{0.9}Sc_{1.53}Ga_{3.4}Al_{0.1}O₁₂ (charges of Gd₂O₃ 0.385 g, Sc₂O₃ 0.1083 g, Al₂O₃ 0.0052 g, Ga₂O₃ 0.327 g, Sm₂O₃ 0.1745 g) single crystals were prepared in the same manner to compare their characteristics.

Discs with a thickness of 1 mm were cut out of the finished single-crystal rods with a diameter of 3 mm and optically polished for the following measurement of absorption spectra. Fig. 14 shows the absorption spectrum of theGd_{2.67}Sm_{0.3}Sc_{1.53}Ga_{3.4}Al_{0.1}O₁₂ single crystal, where the absorption coefficient at 1064 nm reaches the value of 12.3 cm⁻¹. In the Gd_{2.37}Sm_{0.6}Sc_{1.53}Ga_{3.4}Al_{0.1}O₁₂ and Gd_{2.07}Sm_{0.9}Sc_{1.53}Ga_{3.4}Al_{0.1}O₁₂ single crystals, the absorption coefficient at 1064 nm reaches the values of 21.1 cm⁻¹ and 30.6 cm⁻¹ respectively.

### Example 5

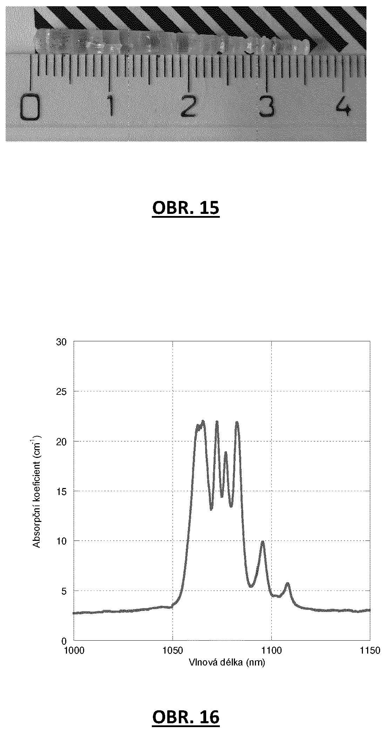

A sample of single crystal of the absorbing material Gd_{1.0}Y_{1.37}Sm_{0.6}Sc_{1.53}Ga_{3.4}Al_{0.1}O₁₂ was prepared as follows:
In a total amount of 1 g, the binary oxides Gd₂O₃, Y₂O₃, Sc₂O₃ Al₂O₃, Ga₂O₃ and Sm₂O₃ with a purity of 5N were mixed at the ratio of the chemical formula Gd_{1.0}Y_{1.37}Sm_{0.6}Sc_{1.53}Ga_{3.4}Al_{0.1}O₁₂ as follows: Gd₂O3 0.1834 g, Y₂O₃ 0.2675 g, Sc₂O₃ 0.1068 g, Al₂O₃ 0.0052 g, Ga₂O₃ 0.3225 g, Sm₂O₃ 0.1147 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from an iridium crucible, see example of grown rod in Fig. 15.

The starting material was placed in an iridium crucible with a circular die with a diameter of 3 mm and a capillary with a diameter of 0.5 mm at the bottom. The height of the after-heater was 20 mm. Both the crucible and the after-heater were inductively heated until the melting point of the starting material was reached. After contact of the undoped Y₃Al₅O₁₂ seed crystal (orientation <111>) with the melt in the capillary, the crystal was pulled down at a rate of 0.03 mm/min until the melt in the crucible was depleted. Then, the induction heating power was gradually reduced down to room temperature, and the crystal was removed. For the Ga-containing crystals, the whole process took place only in an Ir crucible under the atmosphere of gaseous mixture of 1% oxygen with a purity of 99.998% in argon with a purity of 99.998% (Ar: 1% O₂). The flow rate of Ar: Ar + 1% O₂ was 0.5 dm³/min. Oxygen was introduced to suppress the Ga evaporation associated with decomposition of Ga₂O₃ The molybdenum crucible could not be used due to the reaction of Mo with Ga₂O₃ and with O₂.

The Gd_{1.0}Y_{1.67}Sm_{0.3}Sc_{1.53}Ga_{3.4}Al_{0.1}O₁₂ (charges of Gd₂O₃ 0.1832 g, Y₂O₃ 0.3257 g, Sc₂O₃ 0.1066 g, Al₂O₃ 0.0052 g, Ga₂O₃ 0.3221 g, Sm₂O₃ 0.0573 g) and Gd_{1.0}Y_{1.07}Sm_{0.9}Sc_{1.53}Ga_{3.4}Al_{0.1}O₁₂ (charges of Gd₂O₃ 0.1836 g, Y₂O₃ 0.2092 g, Sc₂O₃ 0.1069 g, Al₂O₃ 0.0052 g, Ga₂O₃ 0.3229 g, Sm₂O₃0.1723 g) crystals were prepared in the same manner to compare their characteristics.

Circles with a thickness of 1 mm were cut out of the finished single-crystal rods with a diameter of 3 mm and optically polished for the following measurement of absorption spectra. Fig. 16 shows the absorption spectrum of the Gd_{1.0}Y_{1.37}Sm_{0.6}Sc_{1.53}Ga_{3.4}Al_{0.1}O₁₂ single crystal, where the absorption coefficient at 1064 nm reaches the value of 21.4 cm⁻¹. In the Gd_{1.0}Y_{1.67}Sm_{0.3}Sc_{1.53}Ga_{3.4}Al_{0.1}O₁₂ and Gd_{1.0}Y_{1.07}Sm_{0.9}Sc_{1.53}Ga_{3.4}Al_{0.1}O₁₂ crystals, the absorption coefficient at 1064 nm reaches the values of 12.1 cm⁻¹ and 30.3 cm⁻¹, respectively.

### Example 6

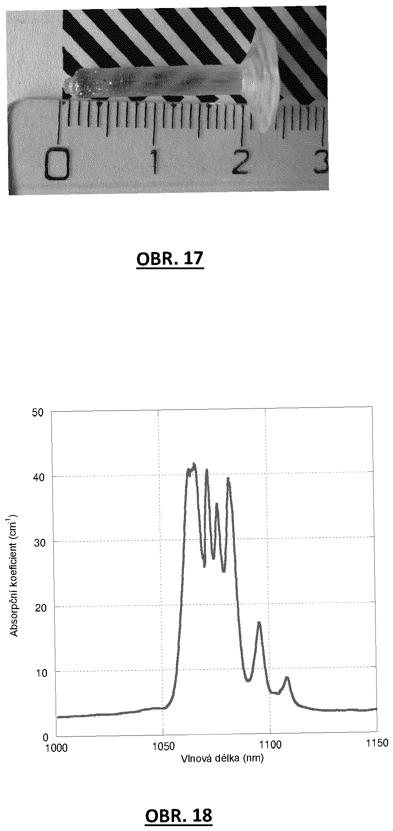

A sample of the single crystal of the absorbing material Gd_{0.5}Lu_{0.5}Y_{0.77}Sm_{1.2}Sc_{1.53}Ga_{3.4}Al_{0.1}O₁₂ was prepared as follows:
In a total amount of 1 g, the binary oxides Gd₂O₃, Y₂O₃, Lu₂O₃ Sc₂O₃ Al₂O₃, Ga₂O₃ and Sm₂O3 with a purity of 5N were mixed at the ratio of the chemical formula Gd_{0.5}Lu_{0.5}Y_{0.77}Sm_{1.2}Sc_{1.53}Ga_{3.4}Al_{0.1}O₁₂ as follows: Gd₂O3 0.0911 g, Y₂O₃ 0.1494 g, Lu₂O₃ 0.1, Sc₂O₃ 0.1061 g, Al₂O₃ 0.0051 g, Ga₂O₃ 0.3204 g, Sm₂O₃0.2279 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from an iridium crucible, see example of the grown rod in Fig. 17.

The starting material was placed in an iridium crucible with a circular die with a diameter of 3 mm and a capillary with a diameter of 0.5 mm at the bottom. The height of the after-heater was 20 mm. Both the crucible and the after-heater were inductively heated until the melting point of the starting material was reached. After the contact of the undoped Y₃Al₅O₁₂ seed crystal (orientation <111>) with the melt in the capillary, the crystal was pulled down at a rate of 0.03 mm/min until the melt in the crucible was depleted. Then, the induction heating power was gradually reduced down to room temperature, and the crystal was removed. For the Ga-containing crystals, the whole process took place only in an Ir crucible under the atmosphere of the gaseous mixture of 1% oxygen with a purity of 99.998% in argon with a purity of 99.998% (Ar: 1% O₂). The flow rate of Ar:Ar + 1% O₂ was 0.5 dm³/min. Oxygen was introduced to suppress the Ga evaporation associated with decomposition of Ga₂O₃ The molybdenum crucible could not be used due to the reaction of Mo with Ga₂O₃ and with O₂.

Discs with a thickness of 1 mm were cut out of the finished single-crystal rod with a diameter of 3 mm and optically polished for the following measurement of absorption spectra.

Fig. 18 shows the absorption spectrum of the Gd_{0.5}Lu_{0.5}Y_{0.77}Sm_{1.2}Sc_{1.53}Ga_{3.4}Al_{0.1}O₁₂ single crystal, where the absorption coefficient at 1064 nm reaches the value of 40.3 cm⁻¹.

### Example 7

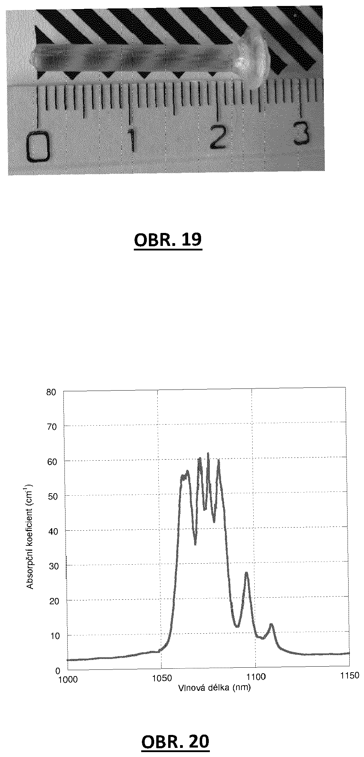

A sample of single crystal of the absorbing material Gd_{0.67}La_{0.2}Sm_{2.1}Sc_{1.53}Ga_{3.4}Al_{0.1}O₁₂ was prepared as follows:
In a total amount of 1 g, the binary oxides Gd₂O₃, La₂O₃, Sc₂O₃, Al₂O₃, Ga₂O₃ and Sm₂O₃ with a purity of 5N were mixed at the ratio of the chemical formula Gd_{0.67}La_{0.2}Sm_{2.1}Sc_{1.53}Ga_{3.4}Al_{0.1}O₁₂ as follows: Gd₂O₃ 0.1239 g, La₂O₃ 0.0332, Sc₂O₃ 0.1077 g, Al₂O₃ 0.0052 g, Ga₂O₃ 0.3251 g, Sm₂O₃ 0.4048 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from an iridium crucible, see example of grown rod in Fig. 19.

The starting material was placed in an iridium crucible with a circular die with a diameter of 3 mm and a capillary with a diameter of 0.5 mm at the bottom. The height of the after-heater was 20 mm. Both the crucible and the after-heater were inductively heated until the melting point of the basic material was reached. After contact of the undoped Y₃Al₅O₁₂ seed crystal(orientation <111>) with the melt in the capillary, the crystal was pulled down at a rate of 0.03 mm/min until the melt in the crucible was depleted. Then, the induction heating power was gradually reduced down to room temperature, and the crystal was removed. For Ga-containing crystals, the whole process took place only in an Ir crucible under the atmosphere of gaseous mixture of 1% oxygen with a purity of 99.998% in argon with a purity of 99.998% (Ar: 1% O₂). The flow rate of Ar:Ar + 1% O₂ was 0.5 dm³/min. Oxygen was introduced to suppress Ga evaporation associated with decomposition of Ga₂O₃ The molybdenum crucible could not be used due to the reaction of Mo with Ga₂O₃ and with O₂.

Disks with a thickness of 1 mm were cut out of the finished single-crystal rod with a diameter of 3 mm and optically polished for the following measurement of absorption spectra.

Fig. 20 shows the absorption spectrum of the Gd_{0.67}La_{0.2}Sm_{2.1}Sc_{1.53}Ga_{3.4}Al_{0.1}O₁₂ single crystal, where the absorption coefficient at 1064 nm reaches the value of 55.3 cm⁻¹.

### Example 8

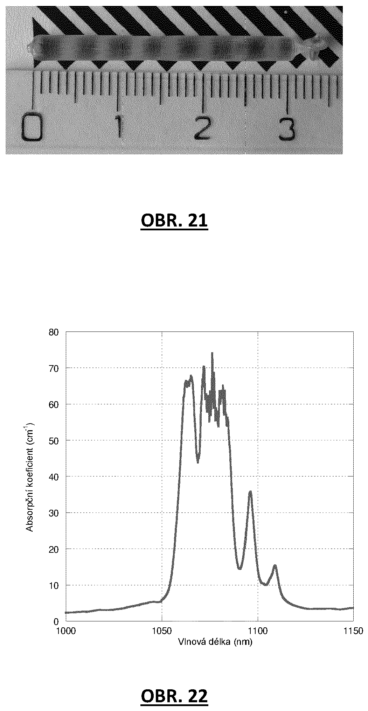

A sample of single crystal of the absorbing material Gd_{0.03}Sm_{2.94}Sc_{1.53}Ga_{3.4}Al_{0.1}O₁₂ was prepared as follows:
In a total amount of 1 g, the binary oxides Gd203, Sc₂O₃, Al₂O₃, Ga₂O₃ a Sm₂O₃ with a purity of 5N were mixed at the ratio of the chemical formula Gd_{0.03}Sm_{2.94}Sc_{1.53}Ga_{3.4}Al_{0.1}O₁₂ as follows: Gd₂O₃ 0.0055 g, Sc₂O₃ 0.1066 g, Al₂O₃ 0.0051 g, Ga₂O₃ 0.3218 g, Sm₂O₃ 0.561 g. Since the total mass is 1 g, the individual charges also correspond to the mass fractions. After mechanical mixing and grinding in a mortar, a two-stage sintering process followed: 1) at 1300°C/24 h, 2) at 1400°C/24 h, in air. Between steps 1) and 2), the material was again mechanically ground in a mortar. This was followed by crystal growth by micro-pulling down (mPD) technique from an iridium crucible, see example of grown rod in Fig. 21.

The starting material was placed in an iridium crucible with a circular die with a diameter of 3 mm and a capillary with a diameter of 0.5 mm at the bottom. The height of the after-heater was 20 mm. Both the crucible and the after-heater were inductively heated until the melting point of the basic material was reached. After contact of the undoped Y₃Al₅O₁₂ seed crystal (orientation <111>) with the melt in the capillary, the crystal was pulled down at a rate of 0.03 mm/min until the melt in the crucible was depleted. Then, the induction heating power was gradually reduced down to room temperature, and the crystal was removed. For Ga-containing crystals, the whole process took place only in an Ir crucible under the atmosphere of gaseous mixture of 1% oxygen with a purity of 99.998% in argon with a purity of 99.998% (Ar: 1% O₂). The flow rate of Ar:Ar + 1% O₂ was 0.5 dm³/min. Oxygen was introduced to suppress Ga evaporation associated with decomposition of Ga₂O₃ The molybdenum crucible could not be used due to the reaction of Mo with Ga₂O₃ and with O₂.

Disks with a thickness of 1 mm were cut out of the finished single-crystal rod with a diameter of 3 mm and optically polished for the following measurement of absorption spectra.

Fig. 22 shows the absorption spectrum of the Gd_{0.03}Sm_{2.94}Sc_{1.53}Ga_{3.4}Al_{0.1}O₁₂ single crystal, where the absorption coefficient at 1064 nm reaches the value of 66.2 cm⁻¹.

### Example 9

The active medium Nd:YAG was diffusely assembled with the layer of the absorbing material Gd_{2.6}SM_{0.3}SC_{0.6}Al_{4.5}O₁₂ on both sides, creating a monolithic element with a length of 24 mm, a height of 12 mm and a width of 8 mm. The side faces 8 × 24 mm were polished to a flatness of 0.5 lambda and were provided with vapour-deposited films transparent for the pump radiation at a wavelength of 808 nm. The front faces 8 × 12 mm were polished to a flatness of 0.1 lambda and were vapour-deposited with dielectric anti-reflection coating for an emitted wavelength of 1064 nm. The upper and lower faces 12 × 24 mm were polished in optical quality to a flatness of 2 lambda. All edges of the monolithic element were equipped with protective facets. The magnitude of the distortion of a waveform of the monolithic element less than or equal to 0.1 lambda in the area of pure aperture Nd:YAG 8 × 8 mm was measured along the length of the element 24 mm.

### Industrial applicability

The absorbing material based on the samarium-doped garnet for suppression of the amplified spontaneous emission of the active medium of solid-state laser and the monolithic element with this absorbing material according to the invention can be particularly used in diode-pumped lasers with high pumping intensity and high peak power in particular in scientific and special applications.

## Claims

1. The absorbing material based on samarium-doped garnet for suppression of the amplified spontaneous emission of the active medium of solid-state laser **characterized in that** it corresponds to the general chemical formula (ReₐSm_{d}Scₑ)₃(AlₓSc_{y}Ga_{z})₅O₁₂, where
the substituent Re represents at least one cation selected from the group: Y³⁺ or a cation from the group of lanthanides or a combination thereof,
the stoichiometric coefficient "a" lies in the interval 0.01 < a < 0.95,
the stoichiometric coefficient "d" lies in the interval 0.05 < d < 1,
the stoichiometric coefficient "e" in the dodecahedral position of the crystal lattice lies in the interval 0.01 < e < 0.3,
where the following relationship applies to the sum of the coefficients a, d, e: a + d + e = 1;
the stoichiometric coefficient "y" in the octahedral position of the crystal lattice lies in the interval 0.1 < y < 0.5,
the stoichiometric coefficient "x" lies in the interval 0.01 < x < 0.9,
and the stoichiometric coefficient "z" lies in the interval 0 < z < 0.9,
where the following relationship applies to the sum of the coefficients y, x, z: y + x + z = 1, where the content of samarium ions is greater than 15 mol%.

2. Absorbing material according to claim 1, **characterized in that** the cation from the group of lanthanides is selected from the group: La, Ce, Pr, Sm, Eu, Gd, Tb, Dy, Ho, Er, Tm, Yb, Lu.

3. Absorbing material according to claim 1 or 2, **characterized in that** the cation from the group of lanthanides is Gd.

4. Use of the absorbing material according to any of claims 1 to 3 to form a monolithic element, where the absorbing material is assembled on at least two sides of the active medium of the solid-state laser.

5. Method of production of the absorbing material according to any of claims 1 to 3, **characterized in that** the absorbing material is prepared as a single crystal from the melt mixture of rare earth oxides and aluminium oxide or scandium oxide or gallium oxide.

6. Method of production of the absorbing material according to any of claims 1 to 3, **characterized in that** the absorbing material is prepared by solid-state sintering from powder raw materials of a mixture of rare earth oxides and aluminium oxide or scandium oxide or gallium oxide.

7. Monolithic element consisting of at least one segment formed by the active medium of a solid-state laser based on neodymium-doped yttrium aluminium garnet (Nd:YAG), which is in the shape of block and is assembled with a layer of absorbing material on at least two sides for suppression of the amplified spontaneous emission of the active medium of the solid-state laser based on samarium-doped garnet **characterized in that** the absorbing material corresponds to the general chemical formula (ReₐSm_{d}Scₑ)₃(AlₓSc_{y}Ga_{z})₅O₁₂, where
the substituent Re represents at least one cation selected from the group: Y³⁺ or a cation from the group of lanthanides or a combination thereof,
the stoichiometric coefficient "a" lies in the interval 0.01 < a < 0.95,
the stoichiometric coefficient "d" lies in the interval 0.05 < d < 1, the stoichiometric coefficient "e" in the dodecahedral position of the crystal lattice lies in the interval 0.01 < e < 0.3,
where the following relationship applies to the sum of the coefficients a, d, e: a + d + e = 1;
the stoichiometric coefficient "y" in the octahedral position of the crystal lattice lies in the interval 0.1 < y < 0.5,
the stoichiometric coefficient "x" lies in the interval 0.01 < x < 0.9,
and the stoichiometric coefficient "z" lies in the interval 0 < z < 0.9,
where the following relationship applies to the sum of the coefficients y, x, z: y + x + z = 1, where the content of samarium ions is greater than 15 mol%.

8. Monolithic element according to claim 7, **characterized in that** the cation from the group of lanthanides is selected from the group: La, Ce, Pr, Sm, Eu, Gd, Tb, Dy, Ho, Er, Tm, Yb, Lu.

9. Monolithic element according to claim 7 or 8, **characterized in that** the cation from the group of lanthanides is Gd.

10. Monolithic element according to any of claims 7 to 9, **characterized in that** the outer walls of the segment of the active medium are ground or polished to remove heat from the active medium and the outer surfaces of the layer of the absorbing material are polished and provided with dielectric layers for the passage of radiation.

11. Monolithic element according to any of claims 7 to 10, **characterized in that** the relationship t > gL/a applies to the thickness of the layer of absorbing material, where
t - is the thickness of the layer of absorbing material
g - is the gain in the active medium per unit thickness of the segment of the active medium
L - is the thickness of the segment of the active medium
a - is the absorption coefficient at the wavelength of amplified spontaneous emission (ASE).
